(19) **Europäisches Patentamt**

**European Patent Office**

**Office européen des brevets**

(11) **EP 1 103 050 B1**

(12) **EUROPÄISCHE PATENTSCHRIFT**

(45) Veröffentlichungstag und Bekanntmachung des Hinweises auf die Patenterteilung:
**27.11.2002 Patentblatt 2002/48**

(21) Anmeldenummer: **99924696.0**

(22) Anmeldetag: **25.03.1999**

(51) Int Cl.$^7$: **G11C 11/22**

(86) Internationale Anmeldenummer:
**PCT/DE99/00921**

(87) Internationale Veröffentlichungsnummer:
**WO 00/005722 (03.02.2000 Gazette 2000/05)**

(54) **RESISTIVE FERROELEKTRISCHE SPEICHERZELLE**

RESISTIVE FERROELECTRIC STORAGE CELL

CELLULE DE MEMOIRE FERROELECTRIQUE RESISTIVE

(84) Benannte Vertragsstaaten:
**DE FR GB IE IT**

(30) Priorität: **22.07.1998 DE 19832993**

(43) Veröffentlichungstag der Anmeldung:
**30.05.2001 Patentblatt 2001/22**

(73) Patentinhaber: **Infineon Technologies AG**
**81669 München (DE)**

(72) Erfinder:
• **KOWARIK, Oskar**
**D-85579 Neubiberg (DE)**
• **HOFFMANN, Kurt**
**D-82024 Taufkirchen (DE)**

(74) Vertreter: **Müller - Hoffmann & Partner**
**Patentanwälte,**
**Innere Wiener Strasse 17**
**81667 München (DE)**

(56) Entgegenhaltungen:
**WO-A-99/14761**          **US-A- 4 712 876**

• **PATENT ABSTRACTS OF JAPAN vol. 1996, no. 11, 29. November 1996 (1996-11-29) & JP 08 180671 A (MATSUSHITA ELECTRIC IND CO LTD), 12. Juli 1996 (1996-07-12)**
• **HARRINGTON D L ET AL: "A GAAS NON-VOLATILE MEMORY" PROCEEDINGS OF THE GALLIUM ARSENIDE INTEGRATED CIRCUIT SYMPOSIUM (GAAS IC),US,NEW YORK, IEEE, Bd. SYMP. 13, Seite 75-78 XP000313128 ISBN: 0-7803-0179-8**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die vorliegende Erfindung betrifft eine resistive ferroelektrische Speicherzelle gemäß dem Oberbegriff des Anspruchs 1.

Ferroelektrische Speicheranordnungen, bei denen die Zellplattenspannung fest auf die halbe Versorgungsspannung (Vcc/2) der Speicheranordnung gelegt ist, zeichnen sich durch schnelle Speicheroperationen aus. Allerdings tritt bei diesen Speicheranordnungen das Problem eines möglichen Verlustes der in den Speicherkondensatoren gespeicherten Daten auf: da die Zellknoten an den Speicherkondensatoren floatend sind, solange die Auswahltransistoren sperren, und diese Zellknoten parasitäre pn-Übergänge zum Halbleitersubstrat bilden, verursachen zwangsläufig auftretende Leckströme über diese pn-Übergänge ein Absinken der Zellknotenspannung auf Massespannung Vss. Die anderen Knoten der ferroelektrischen Speicherkondensatoren bleiben dabei auf der festen Zellplattenspannung Vcc/2 liegen. Dadurch kann der Inhalt der ferroelektrischen Speicherkondensatoren durch Umprogrammieren zerstört werden.

Um diesen Datenverlust zu vermeiden, wird ähnlich wie bei DRAMs ein Refresh der Speicherzellen vorgenommen, bevor deren Inhalt zerstört ist. Der Refresh erfolgt dadurch, daß die Bitleitungen der Speicheranordnung auf die halbe Versorgungsspannung Vcc/2 vorgeladen werden und die Zellknoten durch Aktivierung der Wortleitungen ebenfalls auf die halbe Versorgungsspannung Vcc/2 aufgeladen werden, so daß über den Speicherkondensatoren null Volt abfallen.

Ein solcher Refresh ist aufwendig und erfordert zusätzliche Operationen, die möglichst vermieden werden sollten.

In der unter Art. 54(3)zitierten WO/A99/14761, auf der der Oberbegriff des Anspruchs 1 beruht, ist eine ferroelektrische Speicherzelle offenbart, bei welcher der eigentliche ferroelektrische Speicherkondensator einen Shuntwiderstand aufweist, welcher eine sich aufbaude störende Spannung außerhalb eines Schreibzyklusses oder Lesezyklusses verhindern soll und welcher somit zwischen einer zweiten Elektrode des Speicherkondensators und der Zellenfeldplatte ausgebildet ist.

Es ist daher Aufgabe der vorliegenden Erfindung, eine resistive ferroelektrische Speicherzelle zu schaffen, die so gestaltet ist, daß ein Umprogrammieren der Speicherzelle durch Leckströme am Zellknoten besonders zuverlässig verhindert werden kann, so daß auf einen Refresh der Speicherzelle verzichtet werden kann.

Diese Aufgabe wird bei einer resistiven ferroelektrischen Speicherzelle der im oberbegriff des Anspruches 1 genannten Art erfindungsgemäß dadurch gelöst, daß der Widerstandswert R2 zwischen der anderen Elektrode des Speicherkondensators und der festen Zellplattenspannung derart bemessen ist, daß

$$R3 \ll R2 \ll R1$$

gilt, mit

R1 = Sperrwiderstandswert des pn-Übergangs zwischen der ersten Zone des Auswahltransistors und dem Halbleitersubstrat und

R3 = Widerstandswert zwischen der ersten Zone und einer den ersten Leitungstyp aufweisenden zweiten Zone des Auswahltransistors im eingeschalteten Zustand.

Bei der erfindungsgemäßen Speicherzelle wird so eine Widerstands-Verbindung zwischen dem floatenden Zellknoten und dem anderen Knoten des Speicherkondensators hergestellt, so daß der Leckstrom des parasitären pn-Übergangs kompensiert wird und an beiden Elektroden des Speicherkondensators angenähert die Zellplattenspannung (Vcc/2) anliegt. Damit kann keine ungewollte Umprogrammierung des Speicherkondensators mehr erfolgen. Es sei noch angemerkt, daß der Widerstandswert des gesperrten, ausgeschalteten Auswahltransistors hier noch parallel anliegen kann. Dieser Widerstandswert ist aber in der Regel sehr klein.

Bei der erfindungsgemäßen Speicherzelle ist wesentlich, daß

(a) der Widerstandswert des Widerstandes wesentlich kleiner ist als der Sperrwiderstand des pn-Übergangs und
(b) der floatende Zellknoten in einer kürzeren Zeit als der ansonsten erforderlichen Refreshzeit auf die Zellplattenspannung gezogen wird.

Bei der erfindungsgemäßen resistiven ferroelektrischen Speicherzelle ist sichergestellt, daß einerseits der Lese- und Schreibvorgang durch den Widerstand nahezu nicht gestört ist und andererseits der Leckstrom des parasitären pn-Übergangs durch den Widerstand kompensiert wird und an beiden Seiten des ferroelektrischen Speicherkondensators annähernd die Zellplattenspannung anliegt. Damit kann keine ungewollte Umprogrammierung des Speicherkondensators mehr erfolgen.

Die erste Zone des Auswahltransistors ist vorzugsweise die Drainzone, kann gegebenenfalls aber auch die Sourcezone sein.

Eine Weiterbildung der Erfindung besteht darin, daß der Widerstand als Dickoxid-Transistor zwischen der ersten Zone des Auswahltransistors und einer hochdotierten Zone des ersten Leitungstyps im Halbleitersubstrat vorgesehen ist.

Eine andere Weiterbildung der Erfindung zeichnet sich dadurch aus, daß der Widerstand einen schwach dotierten Bereich des ersten Leitungstyps zwischen der ersten Zone des Auswahltransistors und einer hochdotierten Zone des ersten Leitungstyps im Halbleitersubstrat vorgesehen ist.

Bei beiden obigen Ausführungsmöglichkeiten für den Widerstand ist vorzugsweise die hochdotierte Zone des ersten Leitungstyps über einen Kontaktstöpsel ("plug") aus beispielsweise dotiertem polykristallinem Silizium oder Aluminium mit der einen Elektrode des Speicherkondensators verbunden.

Es ist in vorteilhafter Weise aber auch möglich, den Widerstand direkt zwischen der einen Elektrode und der anderen Elektrode des Speicherkondensators auszubilden. Der Widerstand kann dabei ein hochohmiger polykristalliner Widerstand sein.

An der erfindungsgemäßen resistiven Speicherzelle ist von besonderem Vorteil, daß ein unbeabsichtigtes Umprogrammieren ihres Speicherinhaltes durch einen Leckstrom über dem parasitären pn-Übergang zwischen der ersten Zone und dem diese umgebenden Bereich, also beispielsweise dem Halbleitersubstrat, ausgeschlossen ist. Außerdem ist es ohne weiteres möglich, einen normalen Wortleitungs-Dekoder zu verwenden. Auch wird die Kapazität der Wortleitungen nicht vergrößert. Schließlich kann auch beim Abschalten der Versorgungsspannung keine unbeabsichtigte Umprogrammierung des Speicherinhalts der Speicherzelle erfolgen.

Nachfolgend wird die Erfindung anhand der Zeichnungen näher erläutert. Es zeigen:

Fig. 1 ein Schaltbild eines Speicherzellenfeldes mit erfindungsgemäßen Speicherzellen,

Fig. 2 eine schematische Darstellung eines ersten Ausführungsbeispiels der Erfindung mit einem Dickoxid-Transistor als Widerstand,

Fig. 3 eine schematische Darstellung eines zweiten Ausführungsbeispiels der Erfindung mit einer Gegendotierung in der Oberfläche des Halbleitersubstrates als Widerstand und

Fig. 4 eine schematische Darstellung eines dritten Ausführungsbeispiels der Erfindung mit einem hochohmigen Widerstand aus polykristallinem Silizium zwischen den Elektronen des Speicherkondensators.

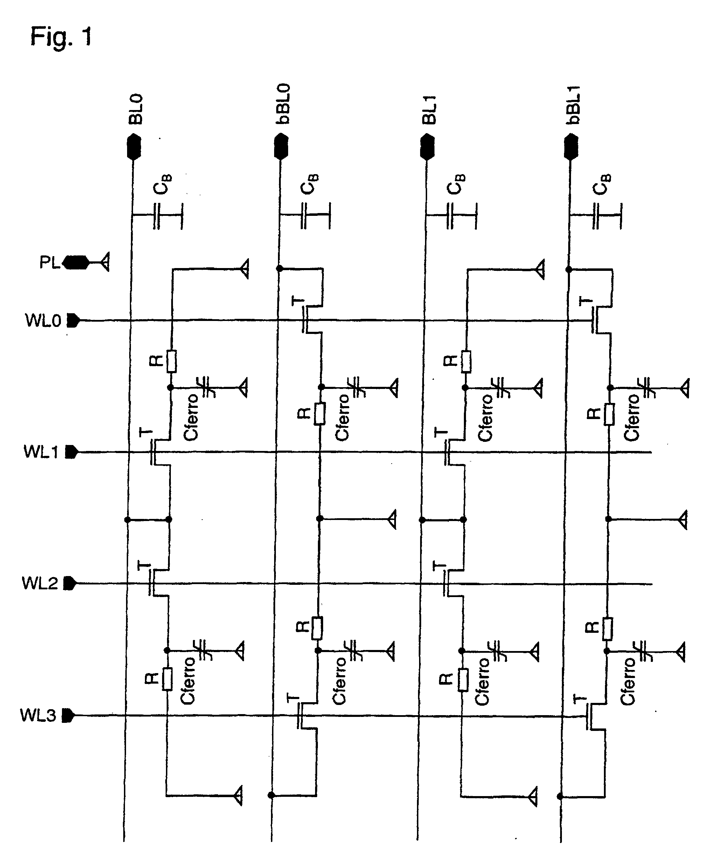

Fig. 1 zeigt ein Speicherzellenfeld in gefalteter Bitleitungsarchitektur mit Wortleitungen WL0, WL1, WL2 und WL3 und Kapazitäten $C_B$ aufweisenden Bitleitungen BL0, bBL0, BL1 und bBL1 für Eintransistor-Einkondensator-(1T1C-)Speicherzellen aus Auswahltransistoren T und ferroelektrischen Speicherkondensatoren Cferro.

An den einen Elektroden der Speicherkondensatoren Cferro liegt eine feste Zellplattenspannung, die erfindungsgemäß jeweils über einen Widerstand R auch der anderen Elektrode des Speicherkondensators zugeführt ist.

Der Widerstandswert R2 dieses Widerstandes R ist so bemessen, daß

$$R3 << R2 << R1$$

gilt, wobei R1 den Sperrwiderstandswert des pn-Überganges des Auswahltransistors und R3 den Widerstandswert zwischen Drain und Source des Auswahltransistors im eingeschalteten Zustand bedeuten.

Die Verbindung der beiden Elektroden des Speicherkondensators erfolgt also über den Widerstand R derart, daß der Widerstandswert R2 dieses Widerstandes wesentlich kleiner ist als der Widerstandswert R1 des Sperrwiderstandes des pn-Überganges und die floatende Elektrode in einer kürzeren Zeit als der ansonsten erforderlichen Refreshzeit auf die Zellplattenspannung gezogen wird.

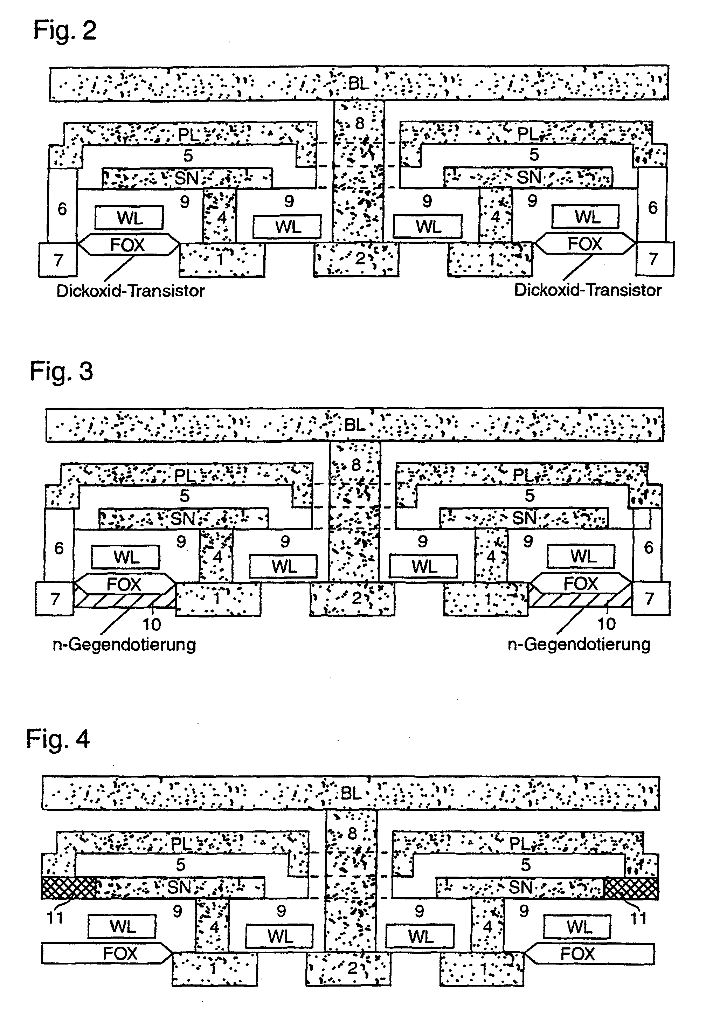

Im folgenden werden anhand der Fig. 2 bis 4 einige Gestaltungsmöglichkeiten für den Widerstand erläutert, wobei einander entsprechende Bauteile jeweils mit den gleichen Bezugszeichen versehen sind.

Fig. 2 zeigt eine beispielsweise n-leitende Drain-Zone 1 und eine ebenfalls n-leitende Source-Zone 2 in einem beispielsweise aus Silizium bestehenden p-leitenden Halbleitersubstrat. Die angegebenen Leitungstypen können, wie auch im folgenden, selbstverständlich umgekehrt sein. Auch ist hier unter "Halbleitersubstrat" der die Zonen 1, 2 umgebende Bereich zu verstehen, bei dem es sich auch um eine Wanne oder dgl. handeln kann. Ferner sind außer Silizium selbstverständlich andere Halbleitermaterialien verwendbar.

Die Drain-Zone 1 ist über einen Stöpsel ("plug") 4 aus beispielsweise dotiertem polykristallinem Silizium oder Aluminium in einer Isolierschicht 9 aus beispielsweise Siliziumdioxid und/oder Siliziumnitrid mit einer Elektrode SN eines ferroelektrischen Speicherkondensators verbunden, dessen andere Elektrode PL auf einer festen Zellplattenspannung liegt und der ein ferroelektrisches Dielektrikum 5 aufweist. Eine Bitleitung BL ist über einen Kontaktstöpsel 8 aus beispielsweise dotiertem polykristallinem Silizium mit der Source-Zone 2 verbunden, während Wortleitungen WL im Bereich zwischen der Drain-Zone 1 und der Source-Zone 2 zur Bildung der Gates der Auswahltransistoren und oberhalb eines Feldoxids FOX aus Siliziumdioxid in die Isolierschicht 9 eingebettet sind.

Die Elektrode PL ist über einen Kontaktstöpsel 6 aus beispielsweise dotiertem polykristallinem Silizium mit einer $n^+$leitenden, hochdotierten Zone 7 im Oberflächenbereich des Halbleitersubstrats verbunden. Dadurch entsteht unterhalb des Feldoxids FOX ein Dickoxid-Transistor, der im Unterschwellstrombereich als Widerstand R wirkt und den Widerstandswert R2 hat, welcher in der oben angegebenen Weise zu bemessen ist. Damit ist die Elektrode PL über den Kontaktstöpsel 6 an die Zone 7 angeschlossen, die mit der im abgetrennten Zustand floatenden Elektrode SN über den Dickoxid-Transistor, die Drain-Zone 1 und den Kontaktstöpsel 4 verbunden ist. Die Einsatzspannung des Dickoxid-Transistors wird beispielsweise durch entsprechende Dotierung unter dem Feldoxid FOX so hoch eingestellt, daß für alle auftretenden Wortleitungsspannungen der Widerstandswert R2 des Dickoxid-Transistors die oben angegebenen Bedingungen erfüllt.

Fig. 3 zeigt ein anderes Ausführungsbeispiel der Erfindung, das sich vom Ausführungsbeispiel der Fig. 2 dadurch unterscheidet, daß der Widerstand R durch einen schwach gegendotierten n-leitenden Bereich 10 unter dem Feldoxid FOX gebildet ist.

Schließlich ist in Fig. 4 ein Ausführungsbeispiel dargestellt, bei dem der Widerstand R durch eine hochohmige Verbindung 11 aus beispielsweise polykristallinem Silizium zwischen der Elektrode PL und der floatenden Elektrode SN realisiert ist.

In allen obigen Ausführungsbeispielen der Fig. 2 bis 4 ist der Widerstandswert R2 des Widerstandes R so zu bemessen, daß er den angegebenen Bedingungen genügt. Dadurch wird eine resistive ferroelektrische Speicherzelle geschaffen, bei der auch ohne "Refresh" der Inhalt des Speicherkondensators durch Umprogrammieren nicht zerstört werden kann.

**Patentansprüche**

1.   Resistive ferroelektrische Speicherzelle aus einem Auswahltransistor und einem Speicherkondensator, dessen eine Elektrode (PL) auf einer festen Zellplattenspannung liegt und dessen andere Elektrode (SN) mit einer einen ersten Leitungstyp aufweisenden ersten Zone (1) des Auswahltransistors verbunden ist, wobei der Auswahltransistor und der Speicherkondensator in einem Halbleitersubstrat eines zweiten, zum ersten Leitungstyp entgegengesetzten Leitungstyps vorgesehen sind, und wobei zwischen der anderen Elektrode (SN) des Speicherkondensators und der festen Zellplattenspannung ein Widerstand R2 (FOX; FOX, 10; 11) vorgesehen ist,
     **dadurch gekennzeichnet,**
     **daß** der Widerstandswert R2 derart bemessen ist, daß

$$R3 \ll R2 \ll R1$$

gilt, mit:

R1 =    Sperrwiderstandswert des pn-Überganges zwischen der ersten Zone (1) des Auswahltransistors und dem Halbleitersubstrat und

R3 =    Widerstandswert zwischen der ersten Zone (1) und einer den ersten Leitungstyp aufweisenden zweiten Zone (2) des Auswahltransistors im eingeschalteten Zustand.

2.   Resistive ferroelektrische Speicherzelle nach Anspruch 1,
     **dadurch gekennzeichnet,**
     **daß** die erste Zone (1) des Auswahltransistors die Drainzone ist.

3.   Resistive ferroelektrische Speicherzelle nach Anspruch 1 oder 2,
     **dadurch gekennzeichnet,**
     **daß** der Widerstand als Dickoxid-Transistor zwischen der ersten Zone (1) des Auswahltransistors und einer hochdotierten Zone (7) des ersten Leitungstyps im Halbleitersubstrat vorgesehen ist.

4.   Resistive ferroelektrische Speicherzelle nach Anspruch 1 oder 2,
     **dadurch gekennzeichnet,**
     **daß** der Widerstand als ein schwach dotierter Bereich des ersten Leitungstyps zwischen der ersten Zone (1) des Auswahltransistors und einer hochdotierten Zone (7) des ersten Leitungstyps im Halbleitersubstrat vorgesehen ist.

5.   Resistive ferroelektrische Speicherzelle nach Anspruch 3 oder 4,
     **dadurch gekennzeichnet,**
     **daß** die hochdotierte Zone (7) des ersten Leitungstyps über einen Kontaktstöpsel (6) mit der einen Elektrode (PL) des Speicherkondensators verbunden ist

6.   Resistive ferroelektrische Speicherzelle nach Anspruch 1 oder 2,
     **dadurch gekennzeichnet,**
     **daß** der Widerstand direkt zwischen der einen Elektrode (PL) und der anderen Elektrode (SN) des Speicherkondensators ausgebildet ist.

7.   Resistive ferroelektrische Speicherzelle nach Anspruch 6,
     **dadurch gekennzeichnet,**
     **daß** der Widerstand ein hochohmiger polykristalliner Widerstand ist.

**Claims**

1.   Resistive ferroelectric memory cell comprising a selection transistor and a storage capacitor, whose one electrode (PL) is at a fixed cell-plate voltage and whose other electrode (SN) is connected to a first zone (1) of the selection transistor, said zone having a first conduction type, the selection transistor and the storage capacitor being provided in a semiconductor substrate of a second conduction type opposite to the first conduction type, and a resistor (FOX; FOX, 10; 11) being provided between the other electrode (SN) of the storage capacitor and the fixed cell-plate voltage, **characterized in that** resistance R2 is such that

$$R3 << R2 << R1,$$

where

R1 = reverse resistance of the pn junction between the first zone (1) of the selection transistor and the semiconductor substrate, and

R3 = resistance between the first zone (1) and a second zone (2) of the selection transistor, said zone having the first conduction type, in the turned-on state.

2. Resistive ferroelectric memory cell according to Claim 1, **characterized in that** the first zone (1) of the selection transistor is the drain zone.

3. Resistive ferroelectric memory cell according to Claim 1 or 2, **characterized in that** the resistor is provided as a thick oxide transistor between the first zone (1) of the selection transistor and a highly doped zone (7) of the first conduction type in the semiconductor substrate.

4. Resistive ferroelectric memory cell according to Claim 1 or 2, **characterized in that** the resistor is provided as a weakly doped region of the first conduction type between the first zone (1) of the selection transistor and a highly doped zone (7) of the first conduction type in the semiconductor substrate.

5. Resistive ferroelectric memory cell according to Claim 3 or 4, **characterized in that** the highly doped zone (7) of the first conduction type is connected to the one electrode (PL) of the storage capacitor via a contact plug (6).

6. Resistive ferroelectric memory cell according to Claim 1 or 2, **characterized in that** the resistor is formed directly between the one electrode (PL) and the other electrode (SN) of the storage capacitor.

7. Resistive ferroelectric memory cell according to Claim 6, **characterized in that** the resistor is a high-resistance polycrystalline resistor.

**Revendications**

1. Cellule de mémoire ferroélectrique résistive constituée d'un transistor de sélection et d'un condensateur de mémoire à l'une des électrodes (PL) de laquelle s'applique une tension fixe de plaque de cellule et dont l'autre électrode (SN) est reliée à une première zone (1) d'un premier type de conductivité du transistor de sélection, le transistor de sélection et le condensateur de mémoire étant prévus dans un substrat semi-conducteur d'un deuxième type de conductivité opposé au premier type de conductivité et il est prévu une résistance (R2 (FOX ; FOX, 10 ; 11) entre l'autre électrode (SN) du condensateur de mémoire et la tension fixe de plaque de cellule,

   **caractérisée en ce que** la valeur R2 de la résistance est telle que

$$R3 << R2 << R1$$

   avec :

   R1 = valeur de la résistance de blocage de la jonction pn entre la première zone (1) du transistor de sélection et le substrat semi-conducteur et

   R3 = valeur de la résistance entre la première zone (1) et une deuxième zone (2) ayant un premier type de conductivité du transistor de sélection à l'état passant.

2. Cellule de mémoire ferroélectrique résistive suivant la revendication 1,

   **caractérisée en ce que** la première zone (1) du transistor de sélection est la zone de drain.

3. Cellule de mémoire ferroélectrique résistive suivant la revendication 1 ou 2,

   **caractérisée en ce que** la résistance est prévue sous la forme d'un transistor à oxyde épais entre la première zone (1) du transistor de sélection et une zone (7) très dopée du premier type de conductivité dans le substrat semi-conducteur.

4. Cellule de mémoire ferroélectrique résistive suivant la revendication 1 ou 2,

   **caractérisée en ce que** la résistance est prévue sous la forme d'une partie faiblement dopée du premier type de conductivité entre la première zone (1) du transistor de sélection et une zone (7) très dopée du premier type de conductivité dans le substrat semi-conducteur.

5. Cellule de mémoire ferroélectrique résistive suivant la revendication 3 ou 4,

   **caractérisée en ce que** la zone (7) très dopée du premier type de conductivité est reliée par l'intermédiaire d'une fiche (6) de contact à l'électrode (PL) du condensateur de mémoire.

6. Cellule de mémoire ferroélectrique résistive suivant la revendication 1 ou 2,

   **caractérisée en ce que** la résistance est constituée directement entre l'électrode (PL) et l'autre électrode (SN) du condensateur de mémoire.

7. Cellule de mémoire ferroélectrique résistive suivant la revendication 6,

   **caractérisée en ce que** la résistance est une résistance polycristalline de grande valeur ohmique.

Fig. 1

## Fig. 2

## Fig. 3

## Fig. 4